(19) Europäisches Patentamt
European Patent Office
Office européen des brevets

(11) EP 1 168 617 A2

(12) **EUROPEAN PATENT APPLICATION**

(43) Date of publication:
02.01.2002 Bulletin 2002/01

(51) Int Cl.7: **H03J 7/04**

(21) Application number: 01305177.6

(22) Date of filing: 14.06.2001

| | |
|---|---|
| (84) Designated Contracting States:<br>**AT BE CH CY DE DK ES FI FR GB GR IE IT LI LU MC NL PT SE TR**<br>Designated Extension States:<br>**AL LT LV MK RO SI** | (72) Inventor: **McCarty, Robert J., Jr.**<br>**Plano, Texas 75903 (US)** |
| (30) Priority: **20.06.2000 US 597002** | (74) Representative: **Brunner, Michael John**<br>**GILL JENNINGS & EVERY, Broadgate House, 7 Eldon Street**<br>**London EC2M 7LH (GB)** |
| (71) Applicant: **Comspace Corporation**<br>**Coppell, TX 75019-4415 (US)** | |

(54) **Closed loop frequency control**

(57)     Closed loop frequency control allows for much closer packing of adjacent transmission channels or sub-channels in that cross channel interference can be adaptively minimized by detecting frequency mismatch between the received signal frequency and the nominal signal frequency. For systems employing quadrature amplitude modulation (QAM), the frequency mismatch can be detected by detecting rotation of the received constellation using a phasor rotation filter. Once phasor rotation is detected, a frequency error value can be derived and a correction value can be transmitted from the receiving unit to the transmitting unit with instruction for the transmitting unit to adjust its transmission frequency accordingly. Frequency mismatch arising from Doppler frequency shift to the transmitted signal can be compensated for, as well as inadvertent oscillator mismatch.

FIG. 4

EP 1 168 617 A2

## EP 1 168 617 A2

**Description**

This invention relates generally to frequency control in a wireless communication system and more specifically to closed loop frequency control system based upon phasor rate compensation.

A typical communication system involves one or more remote units (commonly referred to as subscriber units, mobile units, and the like) and a base unit (often referred to as a base station, a repeater, a cell, and the like). The remote units and the repeater communicate over certain pre-defined communication channels. These channels are centered about a pre-defined frequency, called the center frequency.

While it is desirable that the remote units transmit signals centered exactly about the center frequency, this is often not the case. The oscillator that generates the frequency at which the remote unit transmits oftentimes has an inherent inaccuracy which causes deviation from the desired frequency (for instance, many commercially available oscillators are accurate only to within plus or minus 2000 Hz, or typically 2.5 parts per million, at a common center frequency of 850 MHz). This inaccuracy may vary over time, and as ambient conditions such as temperature, humidity, and the like change. The mobile unit tracks offsets due to environmental conditions using automatic frequency control and aligning frequency to the received repeater signal.

In addition to the inherent inaccuracy of the physical devices, frequency offset may arise as a result of Doppler shifting of the transmitted signal when the remote unit is in motion, such as for a radio or cellular phone in a moving vehicle. The Doppler effect can impart a frequency offset of 100 Hz, 200 Hz, or more to the transmitted signal. The Doppler shift cannot be corrected internal to the mobile receiver since the Doppler shift represents an actual physical frequency offset imposed on the transmitted signal.

As the remote units deviate from their desired center frequency, the risk arises that the transmitted signals of two or more remote units will overlap in the frequency spectrum, and hence with signals received at the repeater will interfere with one another. This interference can result in degradation or loss of the received information signal.

In most prior art systems, individual remote units broadcast on frequency channels that were spaced far apart on the frequency spectrum (or on multiple subcarrier frequencies used by the same transmitter and all Doppler shifted approximately the same amount). Hence, deviations from the desired center frequency did not cause significant degradation. As the frequency spectrum becomes increasingly crowded, however, and as assigned frequency channels become narrower (thus bringing center frequencies closer together), the impact of deviations in the frequencies transmitted by remote units is becoming increasingly significant.

A need exists in the art, therefore, for a system and method for adaptively controlling the frequency at which a remote unit transmits in order to compensate for Doppler shift in the signal transmitted by the remote units.

In one aspect, the present invention provides a method for frequency control in a communications system. The method includes the steps of receiving a signal from a subscriber unit, the signal being centered about a center frequency, comparing the center frequency of the received signal to a nominal center frequency, and detecting a deviation between the center frequency of the received signal and a nominal center frequency. The method further includes deriving a frequency correction value from the detected deviation between the center frequency of the received signal and the nominal center frequency and transmitting the frequency correction value to the subscriber unit.

In another aspect, the present invention provides for a system including a subscriber unit, the subscriber unit including a transmitter outputting a modulated signal, the modulated signal having a pre-defined bandwidth centered about a center frequency. The system also includes a base unit including a receiver, the receiver receiving the modulated signal; a demodulator coupled to the receiver, the demodulator receiving the received modulated signal and outputting a demodulated signal; a filter coupled to the demodulator, receiving the demodulated signal and outputting an error value; a command generator, the command generator receiving the error value and outputting a frequency shift command; a transmitter coupled to the command generator, the transmitter receiving the frequency shift command and transmitting the frequency shift command to the subscriber unit.

The above features of the present invention will be more clearly understood from consideration of the following descriptions in connection with accompanying drawings in which:

Figures 1a and 1b illustrate the frequency spectrum for a preferred embodiment communication channel divided into sub-channels, showing ideal conditions and frequency shifting, respectively;

Figure 2 illustrates a preferred embodiment communications syste m in which the present invention may be employed;

Figure 3 illustrates a QAM constellation showing phasor rotation arising from frequency mismatch between the transmitting and receiving device;

Figure 4 provides a flow chart of a preferred embodiment m ethod for closed loop frequency control.

Figure 5 illustrates the frequency spectrum for another preferred embodiment communication channel divided into sub-channels of differing signal strength; and

Figure 6 is a flow chart of preferred embodiment meth od of using closed loop frequency control to separate sub-channels of different signal strengths.

The making and use of the various embodiments are discussed below in detail. However, it should be appreciated that the present invention provides many applicable inventive concepts that can be embodied in a wide variety of specific contexts. The specific embodiments discussed are merely illustrative of specific ways to make and use the invention, and do not limit the scope of the invention.

In a first preferred embodiment, the present invention will be illustrated as embodied in a system providing closed loop frequency control in multi-carrier architecture. Variations of this first embodiment will then be discussed.

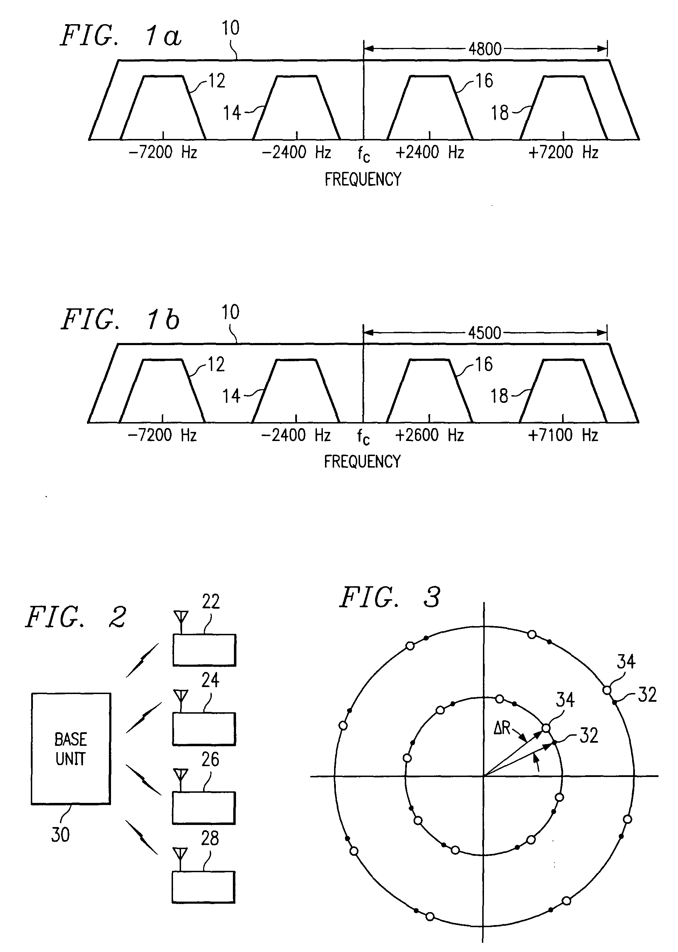

The frequency spectrum for a single channel received by a preferred embodiment multi-carrier architecture base unit (also known as a repeater) is illustrated in Figure 1a. In the multi-carrier architecture, multiple mobile or remote units (also known as subscriber units) can transmit to the repeater on the same frequency channel, each transmitting on a sub-channel defining a portion of the channel's overall frequency bandwidth. Figure 1a illustrates the composite signal received by a base unit for a single 25 kHz wide frequency channel 10, centered about a center frequency $f_c$. In the illustrated embodiment, four subscriber units transmit over the channel, each transmitting on a separate 4 kHz wide sub-channel centered about its own center frequency. The first subscriber unit transmits to the base unit on a sub-channel 12 having a sub-channel center frequency 7200 Hz below the center frequency $f_c$ of the channel 10, the second subscriber unit transmits on a sub-channel 14 having a center frequency 2400 Hz below $f_c$, the third subscriber unit transmits on a sub-channel 16 at 2400 Hz above $f_c$, and the fourth subscriber unit transmits on a sub-channel 18 at 7200 Hz above $f_c$. The illustration shows four subscriber units, each one having its own center frequency. However, the invention applies equally well to systems having many neighboring independent channels that can interfere and are controlled by a central computer. Further information concerning the particular four multi-carri er architecture is provided in co-pending patent application 09/295,660.

Figure 1a illustrates an ideal case where each subscriber unit is transmitting at a reference frequency that exactly matches that of the base unit (i.e. offset from the center frequency $f_c$ by $\pm$ 2400 Hz or $\pm$ 7200 Hz) and wherein the transmitted signals are not subject to frequency shift arising from Doppler shift. Under such ideal conditions, the center frequencies of the sub-channels are spaced apart from one another by 4800 Hz. Figure 1b illustrates a more real world situation where sub-channel 16 has shifted up the frequency spectrum by 200 Hz and sub-channel 18 has shifted down the frequency spectrum by 100 Hz, such shifting arising primarily from Doppler or similar effects. As such, only 4500 Hz separates sub-channels 16 and 18.

Figure 2 illustrates a preferred embodiment system 20 in which subscriber units 22, 24, 26, and 28 transmit over individual sub-channels (such as sub-channels 12, 14, 16, and 18, respectively of Figure 1b) of a defined communications channel, such as an FCC defined 25 kHz channel centered about a center frequency $f_c$ of 850 MHz. Each of the subscriber units transmits to a base unit or repeater 30 on its sub-channel and base unit 30 transmits over the full channel spectrum, but using each of the four sub-channels to communicate with each of the subscriber units individually. Although each subscriber unit receives the entire channel, it demodulates only the sub-channel assigned to it at any given time (the sub-channel assigned to a subscriber unit is preferably assigned by the base unit "on the fly" using load balancing or other well-known techniques). Obviously, the present invention is applicable to systems employing more or fewer subscriber units, more or fewer sub-channels, or a system in which only one subscriber unit transmits on a channel at any given time.

In the preferred embodiment system, the signals are modulated using differential quadrature amplitude modulation (QAM), preferably using a two ring sixteen point constellation, as illustrated in Figure 3. Figure 3 also illustrates the effects that frequency mismatch (between a subscriber unit and the base unit) and Doppler frequency shifts have on the QAM constellation. The nominal constellation points are illustrated as solid dots 32 on the constellation defined by the in-phase and quadrature axes. When the received signal is centered about the nominal center frequency, the constellation points 32 are aligned and no constellation rotation is exhibited. When the received signal is frequency mismatched, however, the constellation is rotated, as illustrated by hollow dots 34.

Constellation rotation, also known as phasor rotation, is detected by use of a phasor rate compensation (PRC) algorithm. Details of a preferred embodiment PRC algorithm are now provided in the following paragraphs and with reference to Figure 3.

Average phase rotation is estimated as a by-product of phase tracking. Phase tracking reconstructs the phase angle as a continuous function avoiding phase bumps by $\pm \pi$. Mathematically, each phasor in the 16 QAM constellation can be written as

$$Ae^{in\pi/4}$$

where $n$ varies from 0 to 7, and A corresponds to the phasor amplitude. Fading and average phasor rotation both affect the received phase angle of the QAM phasor. The received phasor becomes

$$A'e^{i(\frac{n\pi}{4}+\Delta E)}$$

where $\Delta E$ is the error in the phase due to fading and reference oscillator offset. In order to eliminate the effects of quadrature modulation, the received phasor can be raised to the eighth power, giving

$$(A')^8 e^{i(\frac{8n\pi}{4}+8\Delta E)} = (A')^8 e^{i(n2\pi)}(e^{i8\Delta E}) = (A')^8 e^{i8\Delta E}$$

Extracting the angle gives $8\Delta E$, and dividing by 8 yields $\Delta E$ as the remainder ("times eight carrier recovery"). In practice, raising a complex phasor to the eight power is computationally expensive. Preferably, the following approximation is used. The angle of the phasor is extracted and multiplied by eight. The resulting angle is reduced modulo $2\pi$. Discontinuous jumps from $\pi$ to $-\pi$ or from $-\pi$ to $\pi$ are unwrapped by adding multiples of $\pm2\pi$ to the angle (for $-\pi$ to $\pi$ add $2\pi$, and for $\pi$ to $-\pi$ subtract $2\pi$). After the angles are unwrapped, they are divided by eight. The phase difference between consecutive points is averaged for consecutive phase points along the continuous phase curve over a 30 ms time slot to given an estimate of the averaged residual carrier. The average is necessary to smooth the effects of random phase rotation due to fading. The per-slot estimate of phase is used in a control loop to adjust for phase rotation. Other algorithms can be employed as well for phasor rotation compensation. Preferably, times N carrier recovery is employed, where N is selected based upon number of possible phase points in QAM constellation.

The PRC filter outputs a value in radians, which corresponds to the amount of phasor rotation arising from the signal frequency mismatch. This value can be converted into a frequency-offset value using the formula:

$$\text{Frequency error} = (\Delta R / 2\pi) * 4000 \text{ Hz},\qquad(1)$$

where $\Delta R$ is the phase or rotation detected by the PRC filter in radians, and 4000 Hz is the information rate of the preferred embodiment sub-channel.

This frequency error can then be communicated back to the subscriber unit with instructions for the subscriber unit to adjust its oscillator frequency by the amount of the frequency error using well known trunking and control signals.

After the subscriber unit adjusts its frequency, the signal received by the subscriber unit from the repeater is frequency mismatched. Different methods may be used to compensate for the mismatched subscriber units receive frequency. The subscriber unit's oscillator may be toggled between receive and transmit. During transmit, the subscriber unit transmits at the frequency prescribed by the repeater. During receive, the oscillator is tuned to the frequency that was used before the closed loop frequency correction was applied. In the preferred embodiment, the oscillator is adjusted to the frequency commanded by the repeater, and during subscriber unit receive, the receiver complex symbols are counter rotated to offset the shift in subscriber unit receive frequency.

By detecting the frequency mismatch at the base unit and communicating a frequency correction signal back to the subscriber unit(s), the system forms a frequency control closed loop that ensures that individual subscriber units maintain the desired spacing on the frequency spectrum of their respective sub-channels so as to minimize interference with one another at the repeater. Additional details regarding another preferred embodiment system will be provided in the following paragraphs.

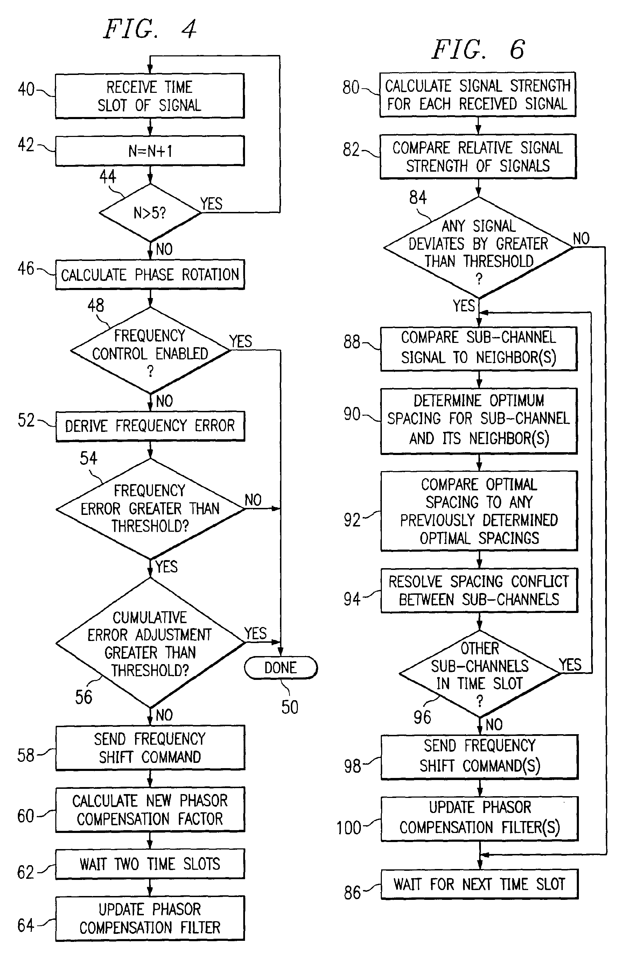

Figure 4 provides a flow chart for a preferred embodiment method of forming closed loop frequency control. In the preferred embodiment, the system comprised of base unit 30 and subscriber units 22, 24, 26, and 28 uses time division multiplexed / frequency division multiplexed architecture and transmits the signal using QAM modulation. Each subscriber unit, therefore, transmits over a single sub-channel of the assigned frequency channel (frequency division), for a portion of the time (time division).

The method begins with step 40 in which the base unit (such as base unit 30 of Figure 2) receives the first time slot of a signal from a subscriber unit (such as subscriber unit 26 of Figure 2), down converts it to base band and demodulates it. At least five time slots are preferably received prior to determining the amount of phasor rotation in order to allow the receipt of a sufficient number of symbols to calculate the constellation rotation. In step 42, a counter, arbitrarily defined as N, is initially set at 0 and increments up to five as each time slot is received. Once five time slots have been received, as indicated in step 44, then N is greater than 5, and processing continues to step 46 where the phasor rotation is calculated. Otherwise, processing loops back to step 40 where another time slot is received until at least five slots of information have been received. In other embodiments, sufficient time for convergence of the PRC filter can be accomplished by counting the number of symbols received, or by delaying further processing for some defined period of time after the initiation of receipt of the signal, or some other alternative. The precise method chosen is not important, provided a means is provided to ensure that the PRC filter has converged prior to further processing.

As stated above, after five slots of the incoming signal have been received, the phasor rotation is calculated in step 46. Processing then proceeds to step 48 where it is determined whether automatic frequency control has been disabled. In most instances this will not be the case, but in the preferred embodiments, the system has the flexibility to allow automatic frequency control to be disabled if needed. If automatic frequency control has been disabled, the method will terminate at this point, as indicated by step 50. Otherwise, processing proceeds to step 52 where the phasor rotation factor determined in steps 40 - 46 is converted to a frequency error value, as described above.

In step 54, the frequency error value determined in step 48 is compared to a threshold value. Lower and upper threshold values are defined as a percentage of the information rate, $R_I$. The thresholds are defined as:

$$TH_I = 1\% * R_I \text{ and } TH_u = 1.75\% * R_I.$$

For the preferred embodiment method, $TH_I$ is 40 Hz and $TH_u$ is 70 Hz. If the frequency error value is greater than $TH_I$, indicating a mismatch between the received signal's center frequency and the nominal center frequency of more than $TH_I$, processing will continue to adjust the subscriber unit's signal frequency. If the error value is less than $TH_I$, however, the mismatch is not so severe as to require adjusting the subscriber unit, and the method will terminate, per step 50. In yet another preferred embodiment, the system will have hysteresis built into it for stability. Preferably, no adjustment to the subscriber unit's signal frequency will be made if the frequency error is less than THI and adjustment will begin only after the error drifts to larger than $TH_u$. Other threshold values defined as different percentages of the information rate, $R_I$, and hysteresis schemes are a matter of routine design experimentation and are contemplated within the scope of the invention.

Assuming the frequency error is greater than the threshold or tolerance value, processing proceeds to step 56, where it is determined whether the subscriber unit has already received a frequency shift command or commands and if so, whether the cumulative effects of those commands would be to adjust the subscriber unit's frequency by more than some threshold amount based on Doppler affect. The Doppler affect threshold is defined as:

$$TH_d = 2*F_s*V_s/c$$

where $F_s$ is a representative carrier frequency for the subscriber unit, $V_s$ is the velocity of the subscriber unit, and c is the speed of light. For $F_s$ of 850 MHz, $V_s$ of seventy miles per hour, the Doppler affect threshold would be approximately 180 Hz at the repeater (After the subscriber unit adjusts for Doppler frequency, the repeater receiver experiences twice the Doppler shift when adjusting to ). This threshold is approximately a worse case total cumulative adjustment that would be required to compensate for the Doppler affect arising from a subscriber unit in a car traveling at roughly seventy miles per hour operating on a carrier frequency of 850 MHz. Other worse case threshold values based on different subscriber vehicle velocities (or oscillator drift) and carrier frequencies are contemplated within the scope of the invention.

No further action on frequency shift commands will be taken by the subscriber unit if the cumulative effects of the prior commands are such as to have adjusted the subscriber unit's oscillator by greater than the Doppler affect threshold amount.

Preferably, the base unit will also determine in step 56 whether an adjustment to the signal frequency of the subscriber unit will cause the unit to transmit outside the boundaries for the assigned channel. If so, either no further adjustments will be made, or the subscriber unit may be instructed to adjust its frequency away from the band edge of the channel.

Assuming further signal frequency adjustment is called for, and/or further adjustment causes the sub-channel to extend beyond the channel boundaries, a command will be sent from the base unit to the appropriate subscriber unit instructing the subscriber unit to adjust its oscillator frequency. The frequency shift command is preferably encoded in trunking and control signals sent to the subscriber units, as is known in the art. Additional details regarding the trunking and control signals are provide in co-pending patent application 09/295,660. In the preferred embodiments, the subscriber unit's frequency is adjusted in increments of $R_{Shift}$ where $R_{Shift}$ is defined in terms of the information rate, $R_I$ as

$$R_{Shift=}0.5\% * R_I$$

Other shift values defined as different percentages of the information rate, $R_I$, are a matter or routine experimentation and are contemplated within the scope of the invention ($R_{Shift}$ is 20 Hz in this case).

After the frequency shift command has been sent to the subscriber unit, the base unit updates its own phasor compensation filter in anticipation of the fact that (once the subscriber unit has acted upon the frequency shift command and has adjusted its oscillator frequency) the received signal will now have a different constellation rotation. The latency associated with re-converging the PRC filter after the received signal frequency has changed can be avoided by adjusting the nominal phasor rate value. This is accomplished using the formula:

$$\Delta R_N = \Delta R_P + (\pm\ R_{Shift} * 2\pi) / R_I \qquad\qquad (2)$$

where $\Delta R_N$ is the new phasor rate compensation value, $\Delta R_P$ is the previous phasor rate compensation value (prior to the change in the signal frequency), and $\pm 20$ Hz is positive or negative depending on whether frequency shift command was to shift the frequency up or down (right or left). This step is illustrated as step 60.

As indicated by step 62, a two time slot latency period is required prior to updating the phasor rate compensation filter with the new value $\Delta R_N$. This delay is because at least two time slots are required to transmit the full command code, including the frequency shift command, to the subscriber unit. In other embodiments, the latency may be more or less, depending on the system design. As the end of the latency period, the repeater updates its phasor compensation factor as shown by step 64.

In another embodiment, the repeater could directly control the subscriber unit only, without using phasor rate compensation. With such a system, latency might lessen the system stability, however. An advantageous feature of the preferred embodiments is the use of closed loop frequency control to minimize interference between communication sub-channels. Phasor rate compensation and closed loop frequency control together provide continuous tracking of the subscriber unit, since the subscriber unit can continuously change its velocity and direction (i.e. in a traveling automobile), thus producing different Doppler effects at the repeater.

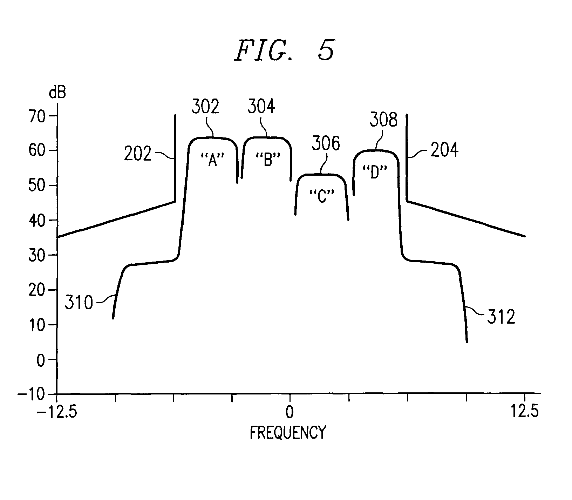

Yet another preferred embodiment method and system for closed loop frequency will now be described with reference to Figure 5 in which the frequency spectrum is shown for an exemplary 25 kHz frequency channel divided into four separate 4 kHz sub-channels. Two subscriber units can transmit on each sub-channel using time division multiplexing, with one subscriber unit transmitting on a sub-channel during one time slot, and a second subscriber unit transmitting on the same sub-channel during a second time slot. Only one time slot is shown in Figure 5.

Note that the signals 302 received on sub-channel "A" a nd 304 received on sub-channel "B" are fairly strong relative the signal 306 received on sub-channel "C." Signal 308 received on sub-channel "D" is also strong relative signal 306. The illustrated signals represent the signals received at base unit 30. The differences in signal strength received at the base unit results from the fact that four different subscriber units transmitted the four signals. The subscriber unit transmitting on sub-channel C may be further from the base unit than the other subscriber units (resulting in greater signal attenuation), or the subscriber unit may be behind large buildings or other signal-blocking obstacles, or the unit may simply have a weak battery and is transmitting at low power to preserve power. For whatever reason, the relatively weak signal 306 makes sub-channel C more vulnerable to cross sub-channel interference from its neighboring sub-channels (B and D, in the illustrated case).

By contrast, sub-channels A and B both have strong signals 302 and 304, respectively, transmitted to the base unit and, although it is preferable to minimize cross sub-channel interference between these signals as well, the sub-channels are less likely to be swamped or significantly degraded by interference with each other.

As discussed in co-pending patent application 09/296,055, entitled Power Control System and Method for Use with Wireless Communications System, filed on April 21, 1999, incorporated herein by reference, closed loop power control may be employed to boost the signal strength being transmitted on sub-channel C or perhaps under appropriate circumstances to decrease the signal strength being transmitted on sub-channels B and D to limit the effects of cross sub-channel interference between signals 304 and 306 and between signals 306 and 308. Alternatively, and in an embodiment of the present invention, closed loop frequency control can be employed to provide additional spacing (on the frequency spectrum) between sub-channels in order to minimize the effects of sub-channel interference on weak signals.

Figure 6 provides a flow chart of a preferred embodiment technique for minimizing sub-channel interference on weak received sub-channel signals. The process begins at step 80, where the four sub-channel signals 302, 304, 306, and 308 are received for a first time slot and the signal strength for each of the signals is calculated using sum of squares after being frequency channelized by the square root Nyquist filter as described in co-pending patent application 09/295,660. In step 82 the signal strength for each of the sub-channels is compared to determine if one or more sub-channel signals is weak relative to its neighbors. If all the sub-channel signals are relatively close in strength, as determined in step 84, then frequency adjustment is not required (for interference purposes) and processing terminates, per step 86, until the next time slot is received. If, however, any one of the sub-channels' signal strength deviates from the other signals by more then some threshold amount, as determined in step 84, than processing continues to step 88. In this step, a first sub-channel signal is compared to its neighboring channels to determine whether the sub-channel, or one or both of its neighboring channels should be moved along the frequency spectrum in order to separate a strong signal and weak signal on adjacent channels. As will be apparent to one skilled in the art, this may be an iterative process to ascertain the optimum sub-channel spacing (within the boundaries 202, 204 of the channel, Fig. 5) because moving a sub-channel in one direction away from a weak neighboring sub-channel might cause it to begin to interfere with another sub-channel. This condition is indicated by the process loop comprising steps 88 and 90 which determines an optimal spacing between the sub-channel under consideration and its neighbors, step 92 which compares the optimal spacing derived in step 90 to any previously determined optimal spacing for the other sub-channel (s), and step 94 in which any conflicts are resolved (e.g. a strong channel might have a weak signal channel on either side and hence should not be shifted in either direction), and finally step 96 where it is determined whether the optimal spacing for all the sub-channels in the communication channel have been analyzed. If other sub-channels remain, the process loops back to step 88 where the next sub-channel is considered and the process loop continues until all sub-channels have been considered.

Different methods can be used to calculate the frequency offset for channel spacing. The theoretical stop band energy in the tails of the Nyquist filter is a criteria that may be used to determine the degree of interference of large amplitude signals with the lower amplitude signal (Figure 5) and adjustments made on the basis of minimizing interference energy within the pass band of the lower energy signal. The expected energy within the pass band of an adjacent channel can be included in table look-up form. Adjustments can also be made adaptively by moving large interfering signals away, and calculating the resulting reduction in bit error rate.

Once all the sub-channels have been analyzed and an optimal spacing of the sub-channels has been derived, processing proceeds to step 98 where commands are sent to one or more subscriber units, as appropriate, to adjust the oscillator frequency and hence the transmit signal center frequency for those subscriber units so as to shift the received signal(s) for optimal spacing. In some cases, however, no frequency shift commands are sent in step 98 if it is determined that the sub-channels are already at or near optimal spacing, or if the feature has been disabled, or if for some other reason it would not be desirable to shift the sub-channel(s). Details on the frequency shift command(s) are provided above with reference to the first and second preferred embodiments. In step 100, the base unit adjusts the phasor rate compensation filters with the new values $\Delta R_N$ for those sub-channels that have been instructed with a frequency shift command, also as described above. Finally, once the commands have been sent and the compensation factors have been updated, processing proceeds to step 86 where the base unit awaits the next time slot of signals.

Note that in this embodiment the frequency control is not intended primarily to counteract the effects of frequency mismatch or Doppler shift, although the present invention contemplates the use of frequency control for either correcting frequency shifts, or for minimizing sub-channel interference, or for accomplishing both simultaneously.

Whenever the repeater commands a frequency shift for mobile transmit, the frequency command results in a commanded change to the frequency oscillator of the subscriber unit after the frequency is converted to voltage. Different ways exist to compensate for the resulting frequency mismatch experienced during subscriber unit receive. In the preferred embodiment, an equivalent phasor offset is used on a per symbol basis to compensate for the frequency oscillator being mismatched to the receive frequency. The compensating $\Delta Q$ for phasor change is given by

$$\Delta Q = (\text{Total command})(2\pi)/ R_I$$

where $R_I$ is the information rate. Using this $\Delta Q$, an angle adjustment is calculated on a per symbol basis as:

$$Cos\_cor = Cos(\Delta Q)$$

$$Sin\_cor = Sin(-\Delta Q)$$

$$Cos\_ang_i = Cos\_cor * Cos\_ang_{i-1} - Sin\_cor * Sin\_ang_{i-1}$$

$$Sin\_ang_i = Sin\_cor * Cos\_ang_{i-1} + Cos\_cor * Sin\_ang_{i-1}$$

The new symbol value becomes

$$\text{In\_phase}_{C_i} = \text{In\_phase}_i * \text{Cos\_ang}_i - \text{Quad\_phase}_i * \text{Sin\_ang}_i$$

$$\text{Quad\_phase}_{C_i} = \text{Quad\_phase}_i * \text{Cos\_ang}_i + \text{In\_phase}_i * \text{Sin\_ang}_i$$

where $\text{In\_phase}_i$ is the downsampled and interpolated value of the In_phase component at the sample time, and $\text{Quad\_phase}_i$ is the downsampled and interpolated value of the quadrature component at the sample time. $\text{In\_phase}_{C_i}$ and $\text{Quad\_phase}_{C_i}$ represent corrected values, and $\text{Cos\_ang}_i$ and $\text{Sin\_ang}_i$ are updated values of the Cosine and Sine used to transform symbol values to current time. The very first In-phase and Quadrature-phase symbol is not adjusted, and the initial values of $\text{Cos\_ang}_1$ and $\text{Sin\_ang}_1$ are 0,1 respectively. Given these changes to the way phasor rotations are calculated, automatic frequency control performs as if the symbol rotation compensation did not exist.

Other methods for freq uency compensating the subscriber unit receive will be obvious to those skilled in the art. Different methods for frequency compensating subscriber units receive are contemplated within the scope of the invention.

One caveat that applies to all the above described embodiments is that care must be taken to ensure that at no time are any of the subscriber units instructed to shift its center frequency so as to cause the subscriber unit to transmit a signal that all or a portion of which falls outside the boundaries of the frequency channel to which the subscriber unit has been assigned (i.e. channel 10 of Figure 1b).

## Claims

1.   A method for frequency control in a communications system comprising:

   receiving a signal from a subscriber unit, the signal being centered about a center frequency;
   comparing the center frequency of the received signal to a nominal center frequency;
   detecting a deviation between the center frequency of the received signal and a nominal center frequency;
   deriving a frequency correction value from the detected deviation between the center frequency of the received signal and the nominal center frequency; and
   transmitting the frequency correction value to the subscriber unit.

2.   The method of claim 1 wherein the received signal is quadrature amplitude modulated and wherein said detecting step is accomplished by detecting phasor rotation in the received constellation when the received signal is demodulated.

3.   The method of claim 2 further comprising translating a detected phasor rotation into said frequency correction value.

4.   The method of claim 1 further comprising deriving a phasor rotation compensation value from the detecting step and updating the phasor compensation value after the frequency correction value has been sent to the subscriber unit.

5.   The method of claim 1 wherein the receiver signal is down-converted to baseband such that the center frequency is 0 Hertz prior to the comparing step.

6.   The method of claim 2 wherein phasor rotation is detected using a times N carrier recovery algorithm.

7.   The method of claim 6 wherein the frequency correction value is derived using the formula:

$$\text{Frequency error} = (\Delta R / 2\pi) * S,$$

where $\Delta R$ is the detected phasor rotation, and S is the symbol rate of the received signal.

8.   The method of claim 1 wherein the subscriber unit comprises an oscillator having a nominal frequency and wherein the subscriber unit receives the correction value, and further comprising:

   djusting the nominal oscillator frequency of the subscriber unit to an adjusted oscillator frequency in response to receipt of the correction value by the subscriber unit; and
compensating for frequency mismatch between the nominal oscillator frequency and the adjusted oscillator frequency when the subscriber unit is in a receiving mode.

9. A system comprising:

a subscriber unit, the subscriber unit including a transmitter outputting a modulated signal, the modulated signal having a pre-defined bandwidth centered about a center frequency;
a base unit, the base unit including
a receiver, the receiver receiving the modulated signal;
a demodulator coupled to the receiver, the demodulator receiving the received modulated signal and outputting a demodulated signal;
a filter coupled to the demodulator, receiving the demodulated signal and outputting an error value;
a command generator, the command generator receiving the error value and outputting a frequency shift command;
a transmitter coupled to the command generator, the transmitter receiving the frequency shift command and transmitting the frequency shift command to the subscriber unit.

10. The system of claim 9 wherein the modulated signal is a quadrature amplitude modulated signal.

11. The system of claim 10 wherein the modulated signal is modulated using a sixteen point two-ring constellation.

12. The system of claim 9 wherein the filter is a phasor rotation compensation filter and wherein the error value is derived by detecting phasor rotation in the demodulated signal.

13. The system of claim 9 wherein the phasor rotation compensation filter is based on an times N carrier recovery algorithm.

14. The system of claim 9 wherein the subscriber unit is a two way radio.

15. The system of claim 9 wherein the subscriber unit is a cellular telephone.

16. The system of claim 9 wherein the subscriber unit further includes
a variable oscillator outputting an output signal having a variable frequency, the variable frequency varying in response to the frequency shift command.

17. The system of claim 16 wherein the variable oscillator varies in response to the frequency shift command when the subscriber unit is in transmission mode and varies in response to a phasor offset command generated within the subscriber unit.

18. A method of closed loop frequency control comprising:

receiving a signal from a remote unit, the signal comprising quadrature amplitude modulated symbols mapped on a quadrature amplitude modulation constellation;
detecting a constellation rotation in the received signal, the constellation rotation arising from a frequency deviation between the frequency at which the signal was received and the frequency at which the signal was demodulated;
deriving a phasor rotation compensation value from the detected constellation rotation;
converting the phasor rotation value into a frequency error value;
determining a frequency shift value to compensate for the frequency error value; and
transmitting the frequency shift value to the remote unit.

19. The method of claim 18 further comprising:
updating the phasor rotation value on the basis of the frequency shift value transmitted to the remote unit.

20. The method of claim 18 wherein constellation rotation in the received signal is detected by filtering the received signal through a times N carrier recovery algorithm.

21. The method of claim 18 wherein the signal received from the remote unit is a radio signal.

22. The method of claim 18 wherein the signal received from the remote unit is modulated using quadrature amplitude modulation and further comprising demodulating the received signal.

*FIG. 1a*

10

4800

12

14

16

18

−7200 Hz          −2400 Hz     f$_c$   +2400 Hz          +7200 Hz

FREQUENCY

*FIG. 1b*

10

4500

12

14

16

18

−7200 Hz          −2400 Hz     f$_c$   +2600 Hz          +7100 Hz

FREQUENCY

*FIG. 2*

22

24

26

28

BASE
UNIT

30

*FIG. 3*

34

32

34

32

ΔR

## FIG. 4

40 — RECEIVE TIME SLOT OF SIGNAL

42 — N=N+1

44 — N>5? — YES

NO

46 — CALCULATE PHASE ROTATION

48 — FREQUENCY CONTROL ENABLED ? — YES

NO

52 — DERIVE FREQUENCY ERROR

54 — FREQUENCY ERROR GREATER THAN THRESHOLD? — NO

YES

56 — CUMULATIVE ERROR ADJUSTMENT GREATER THAN THRESHOLD? — YES

DONE 50

NO

58 — SEND FREQUENCY SHIFT COMMAND

60 — CALCULATE NEW PHASOR COMPENSATION FACTOR

62 — WAIT TWO TIME SLOTS

64 — UPDATE PHASOR COMPENSATION FILTER

## FIG. 6

80 — CALCULATE SIGNAL STRENGTH FOR EACH RECEIVED SIGNAL

82 — COMPARE RELATIVE SIGNAL STRENGTH OF SIGNALS

84 — ANY SIGNAL DEVIATES BY GREATER THAN THRESHOLD ? — NO

YES

88 — COMPARE SUB-CHANNEL SIGNAL TO NEIGHBOR(S)

90 — DETERMINE OPTIMUM SPACING FOR SUB-CHANNEL AND ITS NEIGHBOR(S)

92 — COMPARE OPTIMAL SPACING TO ANY PREVIOUSLY DETERMINED OPTIMAL SPACINGS

94 — RESOLVE SPACING CONFLICT BETWEEN SUB-CHANNELS

96 — OTHER SUB-CHANNELS IN TIME SLOT ? — YES

NO

98 — SEND FREQUENCY SHIFT COMMAND(S)

100 — UPDATE PHASOR COMPENSATION FILTER(S)

86 — WAIT FOR NEXT TIME SLOT

FIG. 5